# EUROPÄISCHE PATENTSCHRIFT

(11) **EP 3 281 261 B1**
(45) Veröffentlichungstag und Bekanntmachung des Hinweises auf die Patenterteilung: **03.11.2021**
(21) Anmeldenummer: 16717583.5
(22) Anmeldetag: 05.04.2016
(51) Int. Cl.: H01S 5/02, H01S 5/042, H01S 5/40, H01S 5/026, H01S 5/20, H01S 5/02345

(54) **MONOLITHISCHE DIODENLASERANORDNUNG**
MONOLITHIC DIODE LASER ARRANGEMENT
AGENCEMENT DE DIODES LASER MONOLITHIQUE

(30) Priorität: 09.04.2015 DE 102015105438
(43) Veröffentlichungstag der Anmeldung: 14.02.2018
(73) Patentinhaber: Dilas Diodenlaser GmbH, 55129 Mainz (DE)
(72) Erfinder: KELEMEN, Marc, 79194 Gundelfingen (DE); HILZENSAUER, Sascha, 79111 Freiburg (DE); GILLY, Jürgen, 79194 Gundelfingen (DE); FRIEDMANN, Patrick, 79263 Simonswald (DE); BIESENBACH, Jens, 59122 Mainz (DE)
(74) Vertreter: Schlögl, Markus
(86) Internationale Anmeldenummer: PCT/EP2016/057452
(87) Internationale Veröffentlichungsnummer: WO 2016/162340

(56) Entgegenhaltungen:
- JP-A- H0 846 279
- US-A- 5 642 373
- US-A- 5 887 012
- US-A1- 2009 190 619

## Beschreibung

Die Erfindung betrifft ein Verfahren zur Herstellung einer monolithischen Diodenlaseranordnung.

Diodenlaseranordnungen bzw. Diodenlaserarrays für Diodenlaser mit hohen Leistungsdichten finden vielfältige Anwendungen in unterschiedlichsten Gebieten, wie etwa dem optischen Pumpen von Festkörper-, Faser- und Scheibenlasern, der direkten Materialbearbeitung oder der medizinischen Therapie bzw. Diagnostik. Halbleiter-Laseranordnungen sind insbesondere aus US 5 642 373 A, JP H08 46279 A, US 5 887 012 A oder US 2009/190619 A1 bekannt.

Die in diesen Anwendungen benötigte optische Leistung kann typischer Weise nicht von einer einzelnen Laserdiode bzw. von einem Einzelemitter bereitgestellt werden. Es ist daher üblich, eine Vielzahl von Einzelemittern in einer Diodenlaseranordnung elektrisch parallel oder in Serie zu schalten.

Typischer Weise sind die bekannten, die Serienschaltung von Einzelemittern betreffenden Diodenlaseranordnungen aus einer Vielzahl von räumlich voneinander getrennten Einzelemittern aufgebaut, die nachträglich in Serie geschaltet werden. Insofern weisen derartige Bauteile keinen monolithischen Aufbau auf. Dies hat eine vergleichsweise aufwändige Optikjustage zur Folge, die für jeden Einzelemitter einzeln erfolgen muss. Zudem müssen die Einzelemitter für gewöhnlich auf separate Wärmesenken aufgebracht werden. Die Anzahl von derart miteinander verschalteten Einzelemittern in der Diodenlaseranordnung liegt meist im Bereich von weniger als zwanzig Stück. Vorteilhaft an derartigen Ausführungen ist der Betriebsstrom der Diodenlaseranordnung, der unabhängig von der Anzahl der Einzelemitter in der Anordnung dem Betriebsstrom des einzelnen Einzelemitters entspricht. Die an der die Serienschaltung aufweisende Diodenlaseranordnung anliegende Spannung entspricht der Summe der an den Einzelemittern anliegenden Spannungen.

Im Falle von Diodenlaseranordnungen, die parallel verschaltete Einzelemitter aufweisen, sind monolithische Ausführungen, sogenannte Diodenlaserarrays oder Barren, bekannt, bei denen die elektrische Kontaktierung auf gegenüberliegenden Seiten der Einzelemitter erfolgt. Derartige monolithische Aufbauten ermöglichen eine einfachere Optikmontage, da für die gesamte Diodenlaseranordnung nur eine einzige Optik pro Kollimationsrichtung benötigt wird. Wesentlicher Nachteil der die Parallelschaltung von Einzelemittern aufweisenden Diodenlaseranordnung sind die zum Betrieb notwendigen großen Ströme, die der Summe der durch die jeweiligen Einzelemitter fließenden Ströme entspricht.

Ausgehend von diesem Stand der Technik ist es Aufgabe der vorliegenden Erfindung, ein verbessertes und effizientes Verfahren zur Herstellung von Diodenlaseranordnung anzugeben.

Diese Aufgabe wird gelöst durch ein Verfahren zur Herstellung einer monolithischen Diodenlaseranordnung und eine entsprechend hergestellte Anordnung wie definiert in den unabhängigen Ansprüchen.

Vorteilhafte Ausführungen der Erfindung sind Gegenstand der Unteransprüche. Eine monolithische Diodenlaseranordnung umfasst eine Vielzahl von auf einem gemeinsamen Trägersubstrat nebeneinander angeordneten Einzelemittern, die jeweils Kontaktfenster zur elektrischen Kontaktierung aufweisen, welche an den jeweiligen Einzelemittern an einer dem Trägersubstrat gegenüberliegenden Vorderseite angeordnet sind.

Zur Erzeugung des Laserlichts weist jeder Einzelemitter eine Rekombinationszone auf, die sich zwischen einem p- und einem n-dotierten Bereich einer mehrschichtigen Epistruktur des jeweiligen Einzelemitters befindet. Diese Epistruktur ist ein mehrschichtiger Aufbau epitaktischer Schichten, die auf einem Episubstrat aufgebracht ist. Das Episubstrat ist von der Epistruktur nicht vollständig überdeckt, so dass auch das Episubstrat mittels eines vorderseitigen Kontaktfensters elektrisch kontaktierbar ist.

Als Episubstrat ist vorzugsweise ein III-V Halbleitermaterial, insbesondere GaAs, InP oder GaSb, vorgesehen, welches in besonders vorteilhafter Weise eine n-Dotierung aufweist.

Die Epistruktur umfasst zumindest eine p-dotierte Mantelschicht und zumindest eine n-dotierte Mantelschicht. In einem konkreten Ausführungsbeispiel der Erfindung umfassen die als Epistruktur auf das Episubstrat aufgebrachten epitaktischen Schichten die Abfolge einer n-dotierten Mantelschicht, einer n-seitigen Wellenleiterschicht, einer Quantentopfstruktur, einer p-seitigen Wellenleiterstruktur, einer p-dotierte Mantelschicht und einer p-dotierten Kontaktschicht. Die das Laserlicht erzeugenden Rekombinationsprozesse finden in diesem bevorzugten Ausführungsbeispiel in der Quantentopfstruktur statt, die beispielsweise von einer InGaAs, InGaAsP, GaInSb und/oder GaInAsSb haltigen Schicht gebildet ist. Die dotierten Mantelschichten und/oder die Wellenleiterschichten bestehen gemäß möglichen Ausführungsbeispielen aus AIGaAs, InGaAsP, AIGaAsSb. Die p-dotierte Kontaktschicht besteht gemäß möglichen Ausführungsbeispielen aus GaAs, GaSb, InP und/oder InGaAs.

Zur elektrischen Kontaktierung der p-dotierten Mantelschicht ist ein p-Kontaktfenster vorderseitig auf der Epistruktur angeordnet. Entsprechend erfolgt die elektrische Kontaktierung der n-dotierten Mantelschicht über ein n-Kontaktfenster, das vorderseitig auf dem Episubstrat im Bereich, in welchem das Episubstrat nicht von der Epistruktur überdeckt ist, angeordnet ist.

Der monolithische, also im Wesentlichen einstückige Aufbau der Diodenlaseranordnung resultiert von einem Vereinzelungsprozess einer räumlich zusammenhängenden Struktur, die die Anordnung der Einzelemitter auf dem Trägersubstrat bestimmt. Diese räumlich zusammenhängende Struktur wird von einem eine entsprechende Schichtstruktur aufweisenden Wafer-Stapel (wafer stack) gebildet, der anschließend durch Anritzen und Spalten vereinzelt, also in die einzelnen Diodenlaseranordnungen aufgeteilt wird.

Die Diodenlaseranordnung gemäß der Erfindung kann somit kostengünstig in großen Stückzahlen hergestellt werden. Darüber hinaus ermöglicht die Anordnung der Einzelemitter auf dem gemeinsamen Trägersubstrat eine vereinfachte Optikmontage, da für die gesamte Diodenlaseranordnung lediglich eine Optik pro Kollimationsrichtung benötigt wird. Gleichzeitig ermöglicht die Anordnung der zur elektrischen Kontaktierung vorgesehenen Kontaktfenster auf der dem Trägersubstrat gegenüberliegenden Vorderseite in besonders vorteilhafter Weise die Serienschaltung der Einzelemitter. Der durch die gesamte Diodenlaseranordnung fließende Betriebsstrom entspricht damit dem Betriebsstrom, der durch jeden der Einzelemitter fließt, so dass eine diesbezügliche Limitierung der Diodenlaseranordnung hinsichtlich der Anzahl der zur Erzeugung des Laserlichts vorgesehenen Einzelemitter entfällt. Im Ergebnis können dadurch besonders leistungsfähige Diodenlaseranordnungen bereitgestellt werden. Zur Kühlung der gesamten Diodenlaseranordnung ist vorzugsweise lediglich eine Wärmesenke vorgesehen, um den Montageaufwand zu minimieren.

Die Einzelemitter der monolithischen Diodenlaseranordnung sind mit dem Trägersubstrat mittelbar über eine dazwischen angeordnete Bondebene verbunden. Derartige Ausführungsbeispiele sind insbesondere hinsichtlich ihrer Herstellung vorteilhaft, da mittels der Bondebene zwei mehrschichtige Schichtstrukturen miteinander verbunden werden können, die vor dem Bonden hinsichtlich ihrer Schichtdicken selektiv auf die speziellen Anfordernisse der herzustellenden Diodenlaseranordnung angepasst werden können. Die Bondebene besteht beispielsweise aus Materialien wie Gold, Aluminium, Germanium, Zinn, einem fotoempfindlichen Epoxidharz, Benzocyclobuten (BCB), einem Polyimid und/oder einem Spin-On-Glass (SOG).

Da gemäß möglicher Ausführungsbeispiele der Erfindung insbesondere elektrisch leitfähige Materialien für das Bonden Verwendung finden können, ist vorzugsweise eine Isolationsschicht zwischen den Einzelemittern und der Bondschicht angeordnet, die somit eine rückseitige elektrische Isolierung der Einzelemitter bereitstellt. Die Verschaltung der Einzelemitter erfolgt über die vorderseitig angeordneten Kontaktfenster.

Besonders bevorzugt sind die Kontaktfenster der Einzelemitter derart mittels metallischen Beschichtungen verbunden, dass die Einzelemitter zueinander elektrisch in Serie geschalten sind. Das Aufbringen dieser metallischen Beschichtung erfolgt auf Waferebene in einem einzigen Herstellungsschritt, also vor dem Vereinzeln der die Anordnung der Einzelemitter auf dem Trägersubstrat definierenden räumlich zusammenhängenden Struktur. Zusätzliche Drahtbondprozesse auf der rückseitigen, also auf der Seite des Trägersubstrats sind hierzu überflüssig.

Vorzugsweise ist eines der p-Kontaktfenster zumindest eines der Einzelemitter mit dem n-Kontaktfenster des dem zumindest einen Einzelemitter benachbarten Einzelemitters mittels der metallischen Beschichtungen elektrisch leitend verbunden. Die metallischen Beschichtungen stellen so die Verschaltung der Einzelemitter in Serie sicher, wobei die zum Stromfluss vorgesehenen elektrisch leitfähigen Verbindungen ausschließlich vorderseitig an der Diodenlaseranordnung angeordnet sind.

Bei einem Verfahren zur Herstellung einer vorstehend beschriebenen monolithischen Diodenlaseranordnung erfolgt die räumlich zusammenhängende Struktur, welche die Ausbildung der die Anordnung der Einzelemitter auf dem Trägersubstrat bestimmt, in einem Strukturierungsschritt auf Waferebene. In dem Strukturierungsschritt werden somit die den Einzelemittern zugeordneten Einzelstrukturen aus einem mehrschichtigen, ein Trägersubstrat umfassenden Grundträger gebildet. Die Ausbildung der Einzelstrukturen im Strukturierungsschritt erfolgt dabei derart, dass diese dabei nicht vom Trägersubstrat bzw. von der Trägersubstratschicht gelöst werden. Die dem Trägersubstrat gegenüberliegenden Vorderseiten der Einzelstrukturen sind zur Ausbildung von Kontaktfenstern vorgesehen.

Die Trägerschicht bildet nach dem Vereinzeln des strukturierten Wafer-Stapels, also nach dem Vereinzeln der die Anordnung der Einzelemitter auf dem Trägersubstrat bestimmenden räumlich zusammenhängenden Struktur, das Trägersubstrat der Diodenlaseranordnung. Entsprechend bilden die den jeweiligen Einzelemittern zugeordneten Einzelstrukturen nach dem Vereinzeln die Einzelemitter zur Erzeugung des Laserlichts.

In einem der vorstehend genannten bevorzugten Ausführungsbeispiele umfasst der Einzelemitter eine die Rekombinationszone beinhaltende Epistruktur, welche auf einem Episubstrat aufgebracht ist. Entsprechend umfasst der zur Strukturierung vorgesehene mehrschichtige Grundträger zumindest eine Epistrukturschicht, eine Episubstratschicht und die Trägersubstratschicht, die auf einer Trägerplatte aufgebracht sind, welche dem Grundträger die nötige mechanische Stabilität während des Herstellungsprozesses gibt.

Im Strukturierungsschritt werden die Epistrukturschicht und die Episubstratschicht des Grundträgers zur Ausbildung der Einzelstrukturen abschnittsweise abgetragen. Dies erfolgt typischer Weise mittels einer Ätzung, auch Separationsätzung genannt, bei der mehrere auf der Trägersubstratschicht angeordnete Einzelstrukturen gebildet werden, ohne dass diese von der Trägersubstratschicht gelöst werden. Die Einzelstrukturen umfassen jeweils auf Episubstraten angeordnete Epistrukturen.

Vorzugsweise wird im Strukturierungsschritt zusätzlich eine so genannte Streifenätzung durchgeführt, bei der Kontaktstreifen zur Strominjektion in die Epistrukturschicht eingebracht werden. Der Kontaktstreifen kann beispielsweise als erhabener Bereich mittig auf der Epistruktur ausgebildet werden.

Bevorzugter Weise wird weiterhin die Epistrukturschicht im Strukturierungsschritt abschnittsweise bis zur Höhe der Episubstratschicht derart abgetragen bzw. durch Ätzen entfernt, dass die Episubstratschicht nicht vollständig von der Epistrukturschicht überdeckt ist. Dieser Strukturierungsschritt kann beispielsweise in einer Isolationsätzung erfolgen, in der die Epistrukturschicht selektiv in bestimmten Bereichen von der darunterliegenden Episubstratschicht entfernt wird, um eine anschließende vorderseitige elektrische Kontaktierung des Episubstrats über in diesen Bereichen angeordnete Kontaktfenster zu ermöglichen.

Vorzugsweise umfasst der Strukturierungsschritt, insbesondere die Separations-, Streifen- und/oder Isolationsätzung eine Lithografie. Derartige Strukturierungsverfahren sind im Bereich der Halbleiterherstellung hinlänglich bekannt und bedürfen keiner weiteren Erläuterung. Die Ätzungen werden vorzugsweise trockenchemisch, insbesondere mittels Plasmaätzen (ICPRIE- oder RIE-Verfahren) durchgeführt, sie können jedoch auch nasschemisch erfolgen.

Die im Strukturierungsschritt gebildete räumlich zusammenhängende Struktur wird gemäß einem möglichen Ausführungsbeispiel in einem dem Strukturierungsschritt anschließenden, vorzugsweise unmittelbar anschließenden Passivierungsschritt ganzflächig mit einer elektrisch isolierenden Passivierungsschicht passiviert bzw. beschichtet. Die Passivierungsschicht besteht beispielsweise aus SiN oder SiO₂.

Anschließend wird die Passivierungsschicht vorzugsweise mittels einer weiteren trocken- oder nasschemischen Ätzung abschnittsweise entfernt. Dies geschieht zur Freilegung der Kontaktfenster, um eine vorderseitige Verschaltung der Einzelemitter zu ermöglichen. Entsprechend wird die zuvor passivierte Epistruktur zur Ausbildung von p-Kontaktfenstern bzw. das zuvor passivierte Episubstrat zur Ausbildung von n-Kontaktfenstern wieder abschnittsweise freigelegt.

Besonders bevorzugt werden die Kontaktfenster in einem anschließenden, insbesondere unmittelbar anschließenden Metallisierungsschritt derart mit metallischen Beschichtungen versehen, dass die den Einzelemittern zugeordneten Einzelstrukturen in Serie geschalten sind. Die Verschaltung der Einzelstrukturen erfolgt somit durch das Aufbringen von entsprechend leitfähigen metallischen Beschichtungen auf Waferebene, d. h. für eine Vielzahl von später durch Vereinzelung gebildeten Diodenlaseranordnungen in einem einzigen Fertigungsschritt. Eine anschließende aufwändige separate Kontaktierung der Einzelemitter kann damit entfallen.

Besonders bevorzugt erfolgt der Metallisierungsschritt in zwei Stufen. In einem ersten Metallisierungsschritt werden erste metallische Beschichtungen auf die räumlich zusammenhängende Struktur aufgebracht, die nach dem Vereinzeln die Diodenlaseranordnung bildet. Die erste metallische Beschichtung kontaktiert lediglich die n-Kontaktfenster auf dem Episubstrat und besteht vorzugsweise aus mehreren metallischen Schichten, wie beispielsweise einer AuGeNi oder einer TiPtAu-Metallfolge. Nach dem Aufbringen der ersten metallischen Beschichtung wird diese einem geeigneten Legierungsverfahren unterzogen. In einem daran anschließenden zweiten Metallisierungsschritt wird zumindest eine zweite metallische Beschichtung aufgebracht, die zumindest eine der die n-Kontaktfenster kontaktierenden ersten metallischen Beschichtungen mit einem p-Kontaktfenster verbindet, welches auf der Epistruktur einer benachbarten Einzelstruktur angeordnet ist. Mit anderen Worten wird durch die elektrisch leitfähige Verbindung, die durch die zweite metallische Beschichtung bereitsteht, eine Reihenschaltung von zumindest zwei Einzelemittern zugeordneten Einzelstrukturen bewirkt. Auch die zweite metallische Beschichtung umfasst vorzugsweise mehrere metallische Schichten, insbesondere eine Kombination von Titan, Platin und Gold, die beispielsweise mittels physikalischer Gasphasenabscheidung, besonders bevorzugt mittels Elektronenstrahlverdampfen, oder mittels eines Sputterverfahrens abgeschieden werden. Derartige Verfahren können auch zur Abscheidung der ersten metallischen Beschichtung zum Einsatz kommen. In anderen Ausführungsbeispielen wird die erste und/oder zweite metallische Beschichtung galvanisch abgeschieden, insbesondere kann die erste und/oder zweite metallische Beschichtung zumindest eine galvanisch abgeschiedene Goldschicht beinhalten. Ferner wird bei Ausführungsbeispielen, bei denen die Diodenlaseranordnung später mittels einer Hartlötung (z.B. AuSn-Lot) auf einer Wärmesenke angeordnet wird, eine entsprechende Platin Barriere als Diffusionssperre für das Hartlot berücksichtigt.

Gemäß der Erfindung ist der Grundträger, der im Strukturierungsschritt eine die spätere Diodenlaseranordnung bestimmende räumlich zusammenhängende Struktur erfährt, aus zumindest zwei Schichtstrukturen gebildet, die in einem Bondingschritt mittels Bonden miteinander verbunden werden. Dies hat zum Vorteil, dass die Schichtdicke der die beiden Schichtstrukturen konstituierenden Schichten selektiv vor dem Strukturierungsschritt angepasst werden kann.

Besonders bevorzugt umfasst die erste Schichtstruktur die Abfolge der Epistrukturschicht, der Episubstratschicht, einer Isolationsschicht und einer ersten Bondschicht. Die Isolationsschicht dient zur elektrischen Isolierung der darüber angeordneten Episubstratschicht von der Bondschicht, die im Allgemeinen elektrisch leitend ist. Die erste Schichtstruktur ist seitens der Epistrukturschicht auf einer weiteren Trägerplatte aufgebracht, die in den vorausgehenden Verfahrensschritten der ersten Schichtstruktur mechanische Stabilität verleiht und entfernt wird, nachdem die erste Bondschicht mit einer zweiten Bondschicht der zweiten Schichtstruktur im Bondingschritt, mithin also die beiden den Grundträger bildenden Schichtstrukturen verbunden wurde.

Die Isolationsschicht besteht vorzugsweise aus SiN oder SiO₂.Die Isolationsschicht wird auf die Episubstratschicht aufgebracht, die vorzugsweise in einem vorhergehenden Verfahrensschritt abgedünnt wurde.

Die Anordnung der ersten Schichtstruktur auf einer weiteren Trägerplatte in einem zumindest dem Bonden vorausgehenden Verfahrensschritt stellt die notwendige Stabilität bereit, so dass die Episubstratschicht auf eine minimal mögliche Substratdicke, die bevorzugt zwischen 50 µm und 100 µm Restdicke liegt, abgedünnt werden kann. Dieser Verfahrensschritt stellt zum einen eine minimale Ätztiefe für die spätere Separationsätzung während des Separationsschrittes sicher, zum anderen wird eine gute Spaltfläche für die Vereinzelung der gebildeten Wafer-Stapel in Diodenlaseranordnungen bzw. Diodenlaserarrays bereitgestellt.

Die zweite Schichtstruktur umfasst die zweite Bondschicht und die Trägersubstratschicht. Die zweite Schichtstruktur wird vorzugsweise seitens der Trägersubstratschicht auf der Trägerplatte aufgebracht und vor dem Aufbringen der zweiten Bondschicht entsprechend abgedünnt. Insbesondere kann die Schichtdicke der Trägersubstratschicht ebenfalls auf zwischen 50 µm und 100 µm Restdicke reduziert werden. Als Materialien der Trägersubstratschicht sind insbesondere sowohl dotierte als auch undotierte III-V Halbleitermaterialien geeignet. In anderen Ausführungsbeispielen kommt ein Siliziumsubstrat als Trägersubstratschicht zum Einsatz.

Als erste und/oder zweite Bondschicht werden dünne Schichten insbesondere aus Au, Al, Ge, Sn, SU8, BCB, Polyimid und/oder SOG auf der Isolationsschicht bzw. auf der Trägersubstratschicht abgeschieden. Die beiden die erste und zweite Bondschicht bildenden Metallebenen werden im Bondingschritt miteinander verbunden. Die hierzu eingesetzten Bondmethoden umfassen vorzugsweise eutektisches Bonden, Adhäsionsbonden oder thermokompressives Bonden.

Die monolithische Diodenlaseranordnung wird gemäß der Erfindung durch Vereinzeln der im Wesentlichen im Strukturierungsschritt gebildeten räumlich zusammenhängenden Struktur gebildet, wobei die räumlich zusammenhängende Struktur gegebenenfalls im Metallisierungsschritt beschichtet wird.

Eine Laservorrichtung gemäß der Erfindung umfasst zumindest eine der vorstehend beschriebenen Diodenlaseranordnungen, so dass zunächst auf die diesbezüglichen Ausführungen verwiesen wird. Derartige Laservorrichtungen können insbesondere zur direkten Materialbearbeitung oder im medizinischen Bereich, beispielsweise im Bereich der medizinischen Therapie oder Diagnose eingesetzt werden. Entsprechend besonders bevorzugten Ausführungsbeispielen umfasst die Laservorrichtung zumindest eine Diodenlaseranordnung mit einer Mehrzahl von in Reihe geschalteten Einzelemittern, die auf einem gemeinsamen Trägersubstrat angeordnet sind. Die zumindest eine Diodenlaseranordnung weist eine Optik pro Kollimationsrichtung auf.

In anderen Ausführungsbeispielen umfasst die Laservorrichtung mehrere Diodenlaseranordnungen, die zueinander elektrisch parallel und/oder in Reihe geschaltet sind, um hohe Leistungen bereit zu stellen.

Besonders bevorzugt umfasst eine Laservorrichtung ein optisches Medium, in welches das von der Diodenlaseranordnung erzeugte Laserlicht zum optischen Pumpen des optischen Mediums einkoppelbar ist. Die Diodenlaseranordnung ist somit Teil eines Pumpmoduls der Laservorrichtung, die beispielsweise als Festkörper-, Faser-, oder Scheibenlaser ausgeführt sein kann.

Im Folgenden werden mögliche Ausführungsbeispiele der Erfindung mit Bezug auf die Zeichnungen näher erläutert. Dabei zeigen:
- Fig. 1:: eine erste und eine zweite Schichtstruktur, vor deren Verbindung zu einem Grundträger in einer schematischen Schnittdarstellung;
- Fig. 2: der in einem Strukturierungsschritt zu einer eine Diodenlaseranordnung definierende räumlich zusammenhängende Struktur strukturierte Grundträger in einer schematischen Schnittdarstellung;
- Fig. 3: die in einem Passivierungsschritt passivierte räumlich zusammenhängende Struktur in einer schematischen Schnittdarstellung;
- Fig. 4: die in einem Metallisierungsschritt mit einer ersten metallischen Beschichtung versehene passivierte Struktur in einer schematischen Schnittdarstellung;
- Fig. 5: die mit einer ersten metallischen Beschichtung versehene passivierte Struktur bzw. die Diodenlaseranordnung in einer schematischen Schnittdarstellung;

Einander entsprechende Teile sind in allen Figuren mit den gleichen Bezugszeichen versehen.

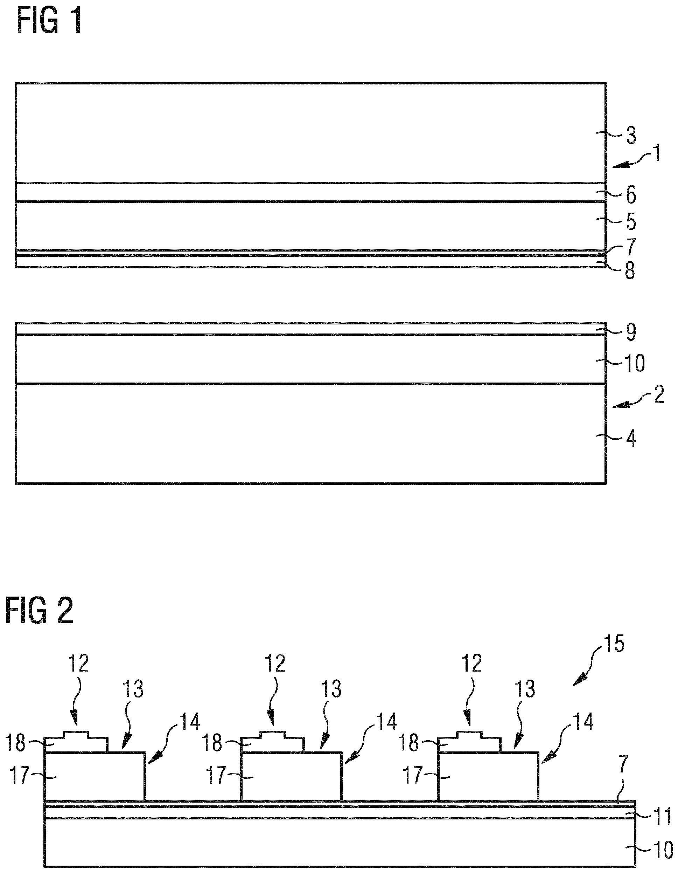

Figur 1 zeigt eine erste Schichtstruktur 1 und eine zweite Schichtstruktur 2 in einer schematischen Schnittdarstellung, die jeweils mehrere auf Trägerplatten 3, 4 angeordnete Schichten von Halbleitermaterialien bzw. Metallen umfassen.

Die erste Schichtstruktur umfasst eine Episubstratschicht 5, welche aus einem III-V Halbleitermaterial besteht. In dem gezeigten Ausführungsbeispiel besteht die Episubstratschicht 5 aus n-dotiertem Galliumarsenid, n-GaAs. Zur Herstellung einer Hochleistungs-Diodenlaseranordnung 100 auf der Basis eines GaAs Substrates werden in einem ersten Herstellungsschritt auf der Episubstratschicht 5 nachfolgend eine n-dotierte Mantelschicht (z.B. AIGaAs, InGaAsP, Al-GaAsSb), eine n-seitige Wellenleiterschicht (z.B. AIGaAs, InGaAsP, AIGaAsSb), eine Quantentopfstruktur (z.B. InGaAs, InGaAsP, GaInSb, GaInAsSb), in der die das Laserlicht erzeugenden Rekombinationsprozesse stattfinden, eine p-seitige Wellenleiterstruktur (z.B. AIGaAs, InGaAsP, AIGaAsSb), eine p-dotierte Mantelschicht (z.B. AIGaAs, InGaAsP, AIGaAsSb) und eine p-dotierte Kontaktschicht (z.B. GaAs, GaSb, InP, InGaAs) abgeschieden. Die Gesamtheit dieser auf der Episubstratschicht 5 abgeschiedenen Schichten wird im Folgenden als Epistrukturschicht 6 bezeichnet.

In einem zweiten Fertigungsschritt wird die Episubstratschicht 5 seitens der Epistrukturschicht 6 vorübergehend auf eine erste Trägerplatte 3 gebondet, so dass die Epistrukturschicht 6 zwischen der ersten Trägerplatte 3 und der Episubstratschicht 5 liegt. Die Episubstratschicht 5 wird anschließend auf eine minimal mögliche Substratdicke mittels herkömmlicher Prozesse abgedünnt, die im Bereich der Halbleiterherstellung hinlänglich bekannt sind und keiner weiteren Erläuterung bedürfen. Dadurch wird unter anderem die in einem anschließenden Strukturierungsschritt notwendige Ätztiefe reduziert und die spätere Vereinzelung der die erste und zweite Schichtstrukturen 1, 2 umfassende Waferstruktur in Diodenlaseranordnungen 100 erleichtert. Anzustreben ist eine Restdicke des Episubstrats 5, die zwischen 50 µm und 100 µm liegt.

In einem dritten Fertigungsschritt wird eine Trägersubstratschicht 10 der zweiten Schichtstruktur 2 ebenfalls auf eine zweite Trägerplatte 4 gebondet und ebenfalls auf etwa 50-100 µm Restdicke abgedünnt. Die Trägersubstratschicht 10 besteht aus einem Trägersubstrat, das im gezeigten Ausführungsbeispiel ein dotiertes III-V Halbleitersubstrat ist.

In anderen Ausführungsbeispielen können auch undotierte III-V Halbleitersubstrate oder Siliziumsubstrat zum Einsatz kommen.

In einem vierten Fertigungsschritt wird das abgedünnte Episubstrat 5 mit einer elektrisch isolierenden Isolationsschicht 7, die in dem gezeigten bevorzugten Ausführungsbeispiel aus SiN besteht, beschichtet. In einem dazu alternativen Ausführungsbeispiel besteht die Isolationsschicht 7 aus SiO₂.

Auf der Isolationsschicht 7 wird eine dünne erste Bondschicht 8 abgeschieden, die aus Gold (Au) besteht. Entsprechend wird auf der Trägersubstratschicht 10 eine dünne zweite Bondschicht 9 abgeschieden, die ebenfalls aus Gold besteht. In anderen Ausführungsbeispielen besteht die erste und/oder zweite Bondschicht 8, 9 aus Al, Ge, Sn, SU8, BCB, Polyimid oder SOG.

Figur 2 zeigt die abgedünnten Episubstrat- und Trägersubstratschichten 5, 10, die vor dem Bonden jeweils auf Trägerplatten 3, 4 aufgebracht sind. Auf der Episubstratschicht 5 ist die Isolationsschicht 7 abgeschieden worden, die die erste Bondschicht 8 trägt. Die Trägersubstratschicht 10 der zweiten Schichtstruktur 2 trägt die zweite Bondschicht 9.

In einem fünften Fertigungsschritt wird die erste Schichtstruktur 1 mit der die erste Bondschicht 8 aufweisenden Seite auf die abgedünnte und beschichtete Trägersubstratschicht 10 gebondet. Die beiden Bondschichten 8, 9 stellen nach dem Bonden eine gemeinsame Bondebene 11 dar, die in den Figuren 2 bis 5 gezeigt ist. Die ersten und zweiten Bondschichten 8, 9 werden im gezeigten Ausführungsbeispiel mittels eutektischem Bonden miteinander verbunden, in anderen Ausführungsbeispielen kann auch Adhäsionsbonden oder thermokompressives Bonden zum Einsatz kommen. Im Ergebnis ist so ein permanent gebondeter Wafer-Stapel (wafer stack) bzw. Grundträger gebildet, der die erste und die zweite Schichtstruktur 1, 2 umfasst. Die erste Trägerplatte 3, die sich auf der Seite der Epistrukturschicht 6 des Grundträgers befindet, wird von diesem gelöst und die oberste Schicht der Epistrukturschicht 6, welcher von der p-dotierten Kontaktschicht gebildet ist, wird gereinigt.

Der gebondete Grundträger wird nun mittels für die Herstellung von Diodenlaseranordnungen 100 üblicher Lithografieverfahren in einem Strukturierungsschritt strukturiert, so dass dieser die in Figur 2 gezeigte räumlich zusammenhängende Struktur 15 erhält. Hierzu werden in einem sechsten Verfahrensschritt zuerst Kontaktstreifen 12 zur Strominjektion durch Ätzen der p-Kontaktschichten der Epistrukturschicht 6 ausgebildet. Durch die Breite der in der Streifenätzung festgelegten Kontaktstreifen 12 wird die Ausdehnung des elektrischen Feldes und die Fläche der Strominjektion definiert.

Danach werden Isolationsgräben 13 mittels einer Isolationsätzung in die Epistrukturschicht 6 eingebracht. Hierzu wird die Epistrukturschicht 6 abschnittsweise von der Episubstratschicht 5 durch Ätzen entfernt. Die Separation der einzelnen zu Einzelemittern 101 der Diodenlaseranordnung 100 zugeordneten Einzelstrukturen 14 erfolgt mittels einer Separationsätzung, die in einer Ätzung des Grundträgers bis zur oberhalb der Bondebene 11 angeordneten Isolationsschicht 7 besteht. Alle Ätzungen werden trockenchemisch, beispielsweise durch ICPRIE oder RIE Verfahren ausgeführt, in anderen Ausführungsbeispielen können die Ätzungen des Strukturierungsschrittes auch nasschemisch erfolgen.

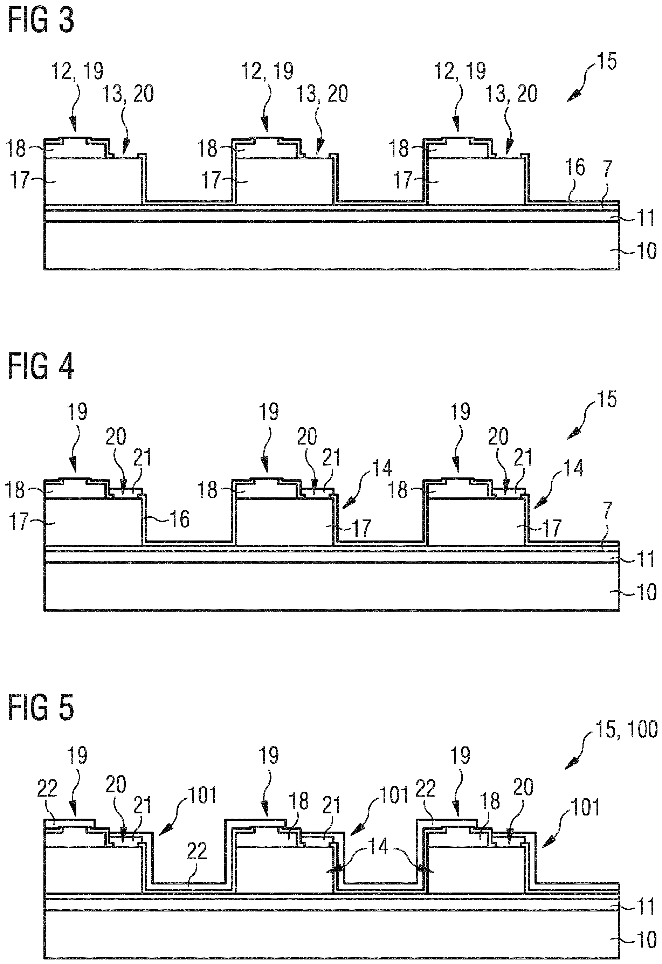

Die Diodenlaseranordnung 100 erhält in dem vorstehend beschriebenen Strukturierungsschritt im Wesentlichen ihre räumlich zusammenhängende Struktur 15, die eine Vielzahl von Einzelstrukturen 14 umfasst, welche auf der Trägersubstratschicht 10 angeordnet sind. Nach Vereinzeln dieser räumlich zusammenhängenden Struktur 15 durch Anritzen und Spalten des Wafer-Stapels bilden die Einzelstrukturen 14 entsprechend die Einzelemitter 101 der Diodenlaseranordnung 100, welche in Figur 5 dargestellt ist. Die Einzelstrukturen 14 umfassen jeweils Episubstrat 17, die abschnittsweise von Epistrukturen 18 überdeckt sind. Die Episubstrate 17 und die Epistrukturen 18 entstehen wie vorstehend beschrieben durch Ätzen des Grundträgers im Strukturierungsschritt aus der Episubstratschicht 5 und der Epistrukturschicht 6. Hinsichtlich der Schichtfolge ist somit die Epistruktur 18 mit der Epistrukturschicht 6 identisch.

Figur 3 illustriert einen dem Strukturierungsschritt anschließenden siebten Verfahrensschritt, in dem die strukturierte Oberfläche der räumlich zusammenhängenden Struktur 15 zunächst ganzflächig mit einer elektrisch isolierenden Passivierungsschicht 16, die beispielsweise aus SiN oder SiO₂ besteht, passiviert wird.

Anschließend wird die Passivierungsschicht 16 durch einen trocken- oder nasschemischen Ätzschritt abschnittsweise auf den Episubstraten 17 und den Epistrukturen 18 strukturiert. Zur Ausbildung von p-Kontaktfenstern 19 wird der Kontaktstreifen 12 der Epistrukturen 18 freigelegt. Entsprechend wird die Passivierungsschicht 16 im Bereich der Isolationsgräben 13 abschnittsweise zur Ausbildung von n-Kontaktfenstern 20 entfernt.

In einem achten Schritt erfolgt die Metallisierung der räumlich zusammenhängenden Struktur 15. Der Metallisierungsschritt ist in dem gezeigten Beispiel zweistufig. Zunächst erfolgt lediglich die N-Metallisierung an den n-Kontaktfenstern 20 mittels Aufbringen von beispielsweise AuGeNi oder TiPtAu-Metallfolgen und anschließender geeigneter Legierungsverfahren, wie in Figur 4 illustriert. Hierbei wird im Bereich der n-Kontaktfenster 20 eine erste metallische Beschichtung 21 aufgebracht, die zur späteren Kontaktierung mit einer zweiten metallischen Beschichtung 22 dient.

Nach dem Aufbringen der abschließenden zweiten metallischen Beschichtung 22, die aus einer Kombination von Titan, Platin und Gold besteht, ist eine der Darstellung von Figur 5 entsprechende Schichtstruktur gebildet. Die zweite metallische Beschichtung 22 wird mittels eines physikalischen Gasabscheideverfahrens aufgebracht, in anderen Ausführungsbeispielen kann hierzu auch ein Sputterverfahren eingesetzt werden. Die zweite metallische Beschichtung 22 verbindet jeweils ein n-Kontaktfenster 20 mit einem p-Kontaktfenster 19 einer benachbarten Einzelstruktur 17 bzw. eines Einzelemitters 101. Mit anderen Worten bewirkt die so aufgebrachte zweite metallische Beschichtung 22 eine Verschaltung der Einzelemitter 101 in Serie.

In einem zehnten Verfahrensschritt wird die Trägerplatte 10 von der Trägersubstratschicht 10 entfernt. Der fertig gestellte Wafer weist die räumlich zusammenhängende Struktur 15 auf, die in Figur 5 gezeigt ist. Der Wafer wird durch Anritzen und Spalten des Wafer-Stapels parallel zur Zeichenebene gespalten und dadurch in die einzelnen Diodenlaseranordnungen 100 vereinzelt. Die senkrecht zur Zeichenebene orientierten Spaltflächen bilden dabei Austrittsseiten für die Laseremission, die anschließend von Halbleiteroxiden und Verunreinigungen mittels geeigneter Verfahren gereinigt und anschließend gekapselt und mit Reflektionsschichten mittels geeigneter Verfahren beschichtet werden.

In einem letzten Schritt werden die in Serie geschalteten Diodenlaseranordnungen 101 mit der Epistruktur 18 auf entsprechend strukturierte Wärmesenken mittels Weichloten (z.B. Indium-Lot) oder Hartloten (z.B. AuSn-Lot) gelötet.

Die so gebildete Diodenlaseranordnung 101 eignet sich besonders für Hochleistungs-Laservorrichtungen. Hierzu können insbesondere mehrere Diodenlaseranordnungen 101 in Serie oder parallel geschaltet werden. Das von Diodenlaseranordnung 101 bereitgestellte Laserlicht kann direkte Verwendung, beispielsweise im Bereich der medizinischen Therapie oder Diagnostik finden oder zum optischen Pumpen eines optischen Mediums Einsatz finden. Entsprechend sind Laservorrichtungen, bei denen die Diodenlaseranordnung 101 Teil eines Pumpmoduls zum optischen Pumpen des optisch aktiven Mediums ebenso Gegenstand der vorliegenden Erfindung, wie Laservorrichtungen, bei denen das von der Diodenlaseranordnung 101 bereitgestellte Licht direkt zum Einsatz kommt.

### Bezugszeichen liste

- 1: erste Schichtstruktur
- 2: zweite Schichtstruktur
- 3: erste Trägerplatte
- 4: zweite Trägerplatte
- 5: Episubstratschicht
- 6: Epistrukturschicht
- 7: Isolationsschicht
- 8: erste Bondschicht
- 9: zweite Bondschicht
- 10: Trägersubstratschicht
- 11: Bondebene
- 12: Kontaktstreifen
- 13: Isolationsgraben
- 14: Einzelstruktur
- 15: Struktur
- 16: Passivierungsschicht
- 17: Episubstrat
- 18: Epistruktur
- 19: p-Kontaktfenster
- 20: n-Kontaktfenster
- 21: erste metallische Beschichtung
- 22: zweite metallische Beschichtung

- 100: Diodenlaseranordnung
- 101: Einzelemitter

## Patentansprüche

1. Verfahren zur Herstellung einer monolithischen Diodenlaseranordnung (100) umfassend eine Vielzahl von auf einem gemeinsamen Trägersubstrat nebeneinander angeordneten Einzelemitter (101), die jeweils Kontaktfenster (19, 20) zur elektrischen Kontaktierung aufweisen, welche an den jeweiligen Einzelemittern (101) an einer dem Trägersubstrat gegenüberliegenden Vorderseite angeordnet sind, wobei jeder Einzelemitter (101) eine mehrschichtige Epistruktur (18) umfasst, die auf einem Episubstrat (17) derart aufbracht ist, dass das Episubstrat (17) von der Epistruktur (18) nicht vollständig überdeckt ist und die Epistruktur (18) zumindest eine p-dotierte Mantelschicht und zumindest eine n-dotierte Mantelschicht umfasst, wobei ein p-Kontaktfenster (19) zur elektrischen Kontaktierung der p-dotierten Mantelschicht vorderseitig auf der Epistruktur (18) angeordnet ist und ein n-Kontaktfenster (20) zur elektrischen Kontaktierung der n-dotierten Mantelschicht vorderseitig auf dem Episubstrat (17) im Bereich, in welchem das Episubstrat (17) nicht von der Epistruktur (18) überdeckt ist, angeordnet ist, wobei die Ausbildung der die Anordnung der Einzelemitter (101) auf dem Trägersubstrat bestimmende räumlich zusammenhängende Struktur (15) in einem Strukturierungsschritt erfolgt, in welchem die den Einzelemittern (101) zugeordneten Einzelstrukturen (14) aus einem mehrschichtigen, ein Trägersubstrat umfassenden Grundträger gebildet werden, ohne dass die Einzelstrukturen (14) vom Trägersubstrat gelöst werden und die dem Trägersubstrat gegenüberliegende Vorderseiten der Einzelstrukturen (14) zur Ausbildung von Kontaktfenstern (19, 20) vorgesehen sind, **dadurch gekennzeichnet, dass** der Grundträger aus zumindest zwei Schichtstrukturen (1, 2) gebildet ist, die in einem Bondingschritt mittels bonden miteinander verbunden werden und die monolithische Diodenlaseranordnung (100) mittels Vereinzeln durch Anritzen und Spalten der räumlich zusammenhängenden Struktur (15) in einer Richtung senkrecht zu die Einzelstrukturen (14) trennenden Gräben gebildet wird.

2. Verfahren nach Anspruch 1, **dadurch gekennzeichnet, dass** der mehrschichtige Grundträger zumindest eine Epistrukturschicht (6), eine Episubstratschicht (5) und eine Trägersubstratschicht (10) umfasst, die auf einer Trägerplatte (4) aufgebracht sind.

3. Verfahren nach Anspruch 2, **dadurch gekennzeichnet, dass** die Epistrukturschicht (6) und die Episubstratschicht (5) des Grundträgers im Strukturierungsschritt zur Ausbildung der Einzelstrukturen (14) abschnittsweise abgetragen werden.

4. Verfahren nach Anspruch 2 oder 3, **dadurch gekennzeichnet, dass** im Strukturierungsschritt Kontaktstreifen (12) zur Strominjektion in die Epistrukturschicht (6) eingebracht werden.

5. Verfahren nach einem der Ansprüche 2 bis 4, **dadurch gekennzeichnet, dass** die Epistrukturschicht (6) im Strukturierungsschritt abschnittsweise bis zur Höhe der Episubstratschicht (5) derart abgetragen wird, dass die Episubstratschicht (5) nicht vollständig von der Epistrukturschicht (6) überdeckt ist.

6. Verfahren nach einem der vorhergehenden Ansprüche, **dadurch gekennzeichnet, dass** der Strukturierungsschritt eine Lithografie umfasst.

7. Verfahren nach einem der vorhergehenden Ansprüche, **dadurch gekennzeichnet, dass** in einem Passivierungsschritt die im Strukturierungsschritt gebildete räumlich zusammenhängende Struktur (15) ganzflächig mit einer Passivierungsschicht (16) passiviert wird.

8. Verfahren nach Anspruch 7, **dadurch gekennzeichnet, dass** Passivierungsschicht (16) mittels einer trocken- oder nasschemischen Ätzung zur Freilegung der Kontaktfenster (19, 20) abschnittsweise entfernt wird.

9. Verfahren nach einem der vorhergehenden Ansprüche, **dadurch gekennzeichnet, dass** die Kontaktfenster (19, 20) in einem Metallisierungsschritt derart mit metallischen Beschichtungen (21, 22) versehen werden, dass die den Einzelemittern (101) zugeordneten Einzelstrukturen (14) in Serie geschalten sind.

10. Verfahren nach Anspruch 9, **dadurch gekennzeichnet, dass** der Metallisierungsschritt zweistufig erfolgt und in einem ersten Metallisierungsschritt erste metallische Beschichtungen (21) auf die räumlich zusammenhängende Struktur (15) aufgebracht werden, die auf dem Episubstrat (17) angeordnete n-Kontaktfenster (20) kontaktieren und in einem zweiten Metallisierungsschritt zumindest eine zweite metallische Beschichtung (22) aufgebracht wird, die zumindest eine der die n-Kontaktfenster (20) kontaktierenden ersten metallischen Beschichtungen (21) mit einem p-Kontaktfenster (19) verbindet, welches auf der Epistruktur (18) einer benachbarten Einzelstruktur (14) angeordnet ist.

11. Verfahren nach einem der vorhergehenden Ansprüche, **dadurch gekennzeichnet, dass** eine erste Schichtstruktur (1) die Abfolge der Epistrukturschicht (6), der Episubstratschicht (5), einer Isolationsschicht (7) und einer ersten Bondschicht (8) umfasst, wobei die erste Schichtstruktur (1) seitens der Epistrukturschicht (6) auf einer weiteren Trägerplatte (3) aufgebracht ist, die entfernt wird, nachdem die erste Bondschicht (8) mit einer zweiten Bondschicht (9) der zweiten Schichtstruktur (2) im Bondingschritt verbunden wurde.

12. Verfahren nach Anspruch 11, **dadurch gekennzeichnet, dass** die zweite Schichtstruktur (2) die zweite Bondschicht (9) und die Trägersubstratschicht (10) umfasst, wobei die zweite Schichtstruktur (2) seitens der Trägersubstratschicht (10) auf der Trägerplatte (4) aufgebracht ist.

13. Monolithische Diodenlaseranordnung (100), die gemäß einem Verfahren der vorgehenden Ansprüche hergestellt wurde.

14. Laservorrichtung mit einer Diodenlaseranordnung (100) nach Anspruch 13.

15. Laservorrichtung nach Anspruch 14, **dadurch gekennzeichnet, dass** die Diodenlaseranordnung (100) zum optischen Pumpen eines optischen Mediums angeordnet ist.

## Claims

1. Method for producing a monolithic diode laser arrangement (100) comprising a multiplicity of individual emitters (101) which are arranged next to one another on a common carrier substrate and which each have contact windows (19, 20) for electrical contacting, which contact windows are arranged on the respective individual emitters (101) on a front side opposite the carrier substrate, each individual emitter (101) comprising a multilayer epistructure (18) which is applied to an episubstrate (17) in such a manner that the episubstrate (17) is not completely covered by the epistructure (18) and the epistructure (18) comprises at least one p-doped cladding layer and at least one n-doped cladding layer, wherein a p-contact window (19) for making electrical contact with the p-doped cladding layer is arranged on the front side of the epistructure (18) and an n-contact window (20) for making electrical contact with the n-doped cladding layer is arranged on the front side of the episubstrate (17) in the region in which the episubstrate (17) is not covered by the epistructure (18), wherein the formation of the spatially coherent structure (15) determining the arrangement of the individual emitters (101) on the carrier substrate takes place in a structuring step in which the individual structures (14) associated with the individual emitters (101) are formed from a multilayer base support comprising a carrier substrate without the individual structures (14) being detached from the carrier substrate, and the front sides of the individual structures (14) opposite the carrier substrate are provided for forming contact windows (19, 20), **characterized in that** the base support is formed from at least two layer structures (1, 2) which are bonded to one another in a bonding step by means of bonding, and the monolithic diode laser arrangement (100) is formed by means of singling by scribing and cleaving the spatially coherent structure (15) in a direction perpendicular to trenches separating the individual structures (14).

2. Method according to claim 1, **characterized in that** the multilayer base support comprises at least an epistructure layer (6), an episubstrate layer (5) and a support substrate layer (10) applied to a support plate (4).

3. Method according to claim 2, **characterized in that** the epistructure layer (6) and the episubstrate layer (5) of the base support are removed in sections in the structuring step to form the individual structures (14).

4. Method according to claim 2 or 3, **characterized in that** contact strips (12) for current injection are introduced into the epistructure layer (6) in the structuring step.

5. Method according to any one of claims 2 to 4, **characterized in that** the epistructure layer (6) is removed in sections in the structuring step up to the height of the episubstrate layer (5) in such a way that the episubstrate layer (5) is not completely covered by the epistructure layer (6).

6. Method according to any one of the preceding claims, **characterized in that** the structuring step comprises lithography.

7. Method according to any one of the preceding claims, **characterized in that**, in a passivation step, the spatially coherent structure (15) formed in the structuring step is passivated over the entire surface with a passivation layer (16).

8. Method according to claim 7, **characterized in that** passivation layer (16) is removed in sections by means of a dry or wet chemical etching to expose the contact windows (19, 20).

9. Method according to any one of the preceding claims, **characterized in that** the contact windows (19, 20) are provided with metallic coatings (21, 22) in a metallization step in such a way that the individual structures (14) associated with the individual emitters (101) are connected in series.

10. Method according to claim 9, **characterized in that** the metallization step is carried out in two steps and, in a first metallization step, first metallic coatings (21) are applied to the spatially coherent structure (15) which contact n-contact windows (20) arranged on the episubstrate (17), and in a second metallization step at least one second metallic coating (22) is applied which connects at least one of the first metallic coatings (21) contacting the n-contact windows (20) to a p-contact window (19) which is arranged on the epistructure (18) of an adjacent individual structure (14).

11. Method according to any one of the preceding claims, **characterized in that** a first layered structure (1) comprises the sequence of the epistructure layer (6), the episubstrate layer (5), an insulating layer (7) and a first bonding layer (8), wherein the first layered structure (1) is applied on the part of the epistructure layer (6) on a further support plate (3) which is removed after the first bonding layer (8) has been bonded to a second bonding layer (9) of the second layered structure (2) in the bonding step.

12. Method according to claim 11, **characterized in that** the second layer structure (2) comprises the second bond layer (9) and the support substrate layer (10), wherein the second layer structure (2) is applied on the support plate (4) on the part of the support substrate layer (10).

13. A monolithic diode laser assembly (100) fabricated according to a method of the preceding claims.

14. Laser device comprising a diode laser assembly (100) according to claim 13.

15. Laser device according to claim 14, **characterized in that** the diode laser assembly (100) is arranged for optically pumping an optical medium.

## Revendications

1. Procédé de fabrication d'un dispositif laser à diode monolithique (100) comprenant une pluralité d'émetteurs individuels (101) disposés les uns à côté des autres sur un substrat de support commun, qui présentent chacun des fenêtres de contact (19, 20) pour la mise en contact électrique, lesquelles fenêtres de contact sont disposées sur les émetteurs individuels (101) respectifs sur une face avant opposée au substrat de support, chaque émetteur individuel (101) comprenant une épistructure multicouche (18) qui est appliquée sur un épisubstrat (17) de telle sorte que l'épisubstrat (17) n'est pas entièrement recouvert par l'épistructure (18) et l'épistructure (18) présente au moins une couche de revêtement à dopage p et au moins une couche de revêtement à dopage n, que l'épisubstrat (17) n'est pas entièrement recouvert par l'épistructure (18) et que l'épistructure (18) comprend au moins une couche de revêtement à dopage p et au moins une couche de revêtement à dopage n, une fenêtre de contact p (19) pour la mise en contact électrique de la couche de revêtement à dopage p étant disposée sur la face avant de l'épistructure (18) et une fenêtre de contact n (20) pour la mise en contact électrique de la couche de revêtement à dopage n étant disposée sur la face avant de l'épisubstrat (17) dans la région de l'épisubstrat (17), dans lequel l'épisubstrat (17) n'est pas recouvert par l'épistructure (18), dans lequel la formation de la structure cohérente dans l'espace (15) déterminant la disposition des émetteurs individuels (101) sur le substrat porteur a lieu dans une étape de structuration dans laquelle les structures individuelles (14) associées aux émetteurs individuels (101) sont formées à partir d'un support de base multicouche comprenant un substrat porteur, sans que les structures individuelles (14) soient détachées du substrat de support, et les faces avant des structures individuelles (14) opposées au substrat de support sont prévues pour former des fenêtres de contact (19, 20), **caractérisé en ce que** le support de base est formé d'au moins deux structures en couches (1, 2), qui sont liées l'une à l'autre dans une étape de liaison au moyen d'un collage, et le dispositif laser à diode monolithique (100) est formé au moyen d'une séparation en rayant et en clivant la structure spatialement cohérente (15) dans une direction perpendiculaire aux tranchées séparant les structures individuelles (14).

2. Procédé selon la revendication 1, **caractérisé en ce que** le support de base multicouche comprend au moins une couche d'épistructure (6), une couche d'épisubstrat (5) et une couche de substrat de support (10), qui sont appliquées sur une plaque de support (4).

3. Procédé selon la revendication 2, **caractérisé en ce que** la couche d'épistructure (6) et la couche d'épisubstrat (5) du support de base sont enlevées par sections dans l'étape de structuration pour former les structures individuelles (14).

4. Procédé selon la revendication 2 ou 3, **caractérisé en ce que** des bandes de contact (12) pour l'injection de courant sont introduites dans la couche d'épistructure (6) dans l'étape de structuration.

5. Procédé selon l'une des revendications 2 à 4, **caractérisé en ce que** la couche d'épistructure (6) est enlevée par sections dans l'étape de structuration jusqu'à la hauteur de la couche d'épisubstrat (5) de telle sorte que la couche d'épisubstrat (5) ne soit pas complètement recouverte par la couche d'épistructure (6).

6. Procédé selon l'une des revendications précédentes, **caractérisé en ce que** l'étape de structuration comprend la lithographie.

7. Procédé selon l'une des revendications précédentes, **caractérisé en ce que** dans une étape de passivation, la structure spatialement cohérente (15) formée dans l'étape de structuration est passivée sur toute la surface avec une couche de passivation (16).

8. Procédé selon la revendication 7, **caractérisé en ce que** la couche de passivation (16) est enlevée par sections au moyen d'une gravure chimique sèche ou humide pour exposer les fenêtres de contact (19, 20).

9. Procédé selon l'une des revendications précédentes, **caractérisé en ce que** les fenêtres de contact (19, 20) sont pourvues de revêtements métalliques (21, 22) dans une étape de métallisation de telle sorte que les structures individuelles (14) associées aux émetteurs individuels (101) soient montées en série.

10. Procédé selon la revendication 9, **caractérisé en ce que** l'étape de métallisation est réalisée en deux étapes et dans une première étape de métallisation, des premiers revêtements métalliques (21) sont appliqués sur la structure cohérente dans l'espace (15), qui sont en contact avec des fenêtres de contact n (20) disposées sur l'épisubstrat (17), et dans une deuxième étape de métallisation, on applique au moins un deuxième revêtement métallique (22) qui relie au moins l'un des premiers revêtements métalliques (21) en contact avec les fenêtres de contact n (20) à une fenêtre de contact p (19) qui est disposée sur l'épistructure (18) d'une structure individuelle adjacente (14).

11. Procédé selon l'une des revendications précédentes, **caractérisé en ce qu'**une première structure en couches (1) comprend la séquence de la couche d'épistructure (6), de la couche d'épisubstrat (5), d'une couche isolante (7) et d'une première couche de liaison (8), la première structure en couches (1) étant appliquée sur la partie de la couche d'épistructure (6) à une autre plaque de support (3) qui est retirée après que la première couche de liaison (8) a été liée à une deuxième couche de liaison (9) de la deuxième structure en couches (2) dans l'étape de liaison.

12. Procédé selon la revendication 11, **caractérisé en ce que** la deuxième structure de couche (2) comprend la deuxième couche de liaison (9) et la couche de substrat de support (10), la deuxième structure de couche (2) étant appliquée sur la plaque de support (4) sur la partie de la couche de substrat de support (10).

13. Un ensemble laser à diode monolithique (100) fabriqué selon un procédé des revendications précédentes.

14. Dispositif laser comprenant un ensemble laser à diode (100) selon la revendication 13.

15. Dispositif laser selon la revendication 14, **caractérisé en ce que** l'ensemble laser à diode (100) est agencé pour pomper optiquement un milieu optique.
